# EUROPEAN PATENT APPLICATION

(11) **EP 4 027 150 A1**
(43) Date of publication of application: **13.07.2022**
(21) Application number: 21150593.8
(22) Date of filing: 07.01.2021
(51) Int. Cl.: G01R 31/28

(54) **TESTING DEVICE AND METHOD FOR REDUCING VIBRATION IN A TESTING DEVICE**

(71) Applicant: Afore Oy, 21420 Lieto (FI)
(72) Inventor: HENTTONEN, Vesa, 20520 Turku (FI); KUUKKALA, Ari, 20540 Turku (FI); MIKOLA, Sami, 23100 Mynämäki (FI); REMES, Matti, 20610 Turku (FI)
(74) Representative: Berggren Oy

(57) **Abstract**

The present invention relates to a testing device that comprises a movable support (106), a chuck (101) attached to the movable support (106) for holding a semiconductor wafer (102) that comprises integrated circuits, a fixed support (108), a probe card (103) attached to the fixed support (108) for probing the integrated circuits on the semiconductor wafer (102), an actuator (107) attached to the movable support (106) for moving the chuck (101) between probing positions so that the integrated circuits on the semiconductor wafer (102) can be tested, and at least one pin (112) attached to the movable support (106) or the chuck (101) in such a manner that when the chuck (101) is at the probing position the at least one pin (112) is pressed against the fixed support (108). The invention also relates to a method for reducing vibration in a testing device.

## Description

### TECHNICAL FIELD OF THE INVENTION

The present invention relates to a testing device and a method for reducing vibration in a testing device according to the preambles of the appended independent claims.

### BACKGROUND OF THE INVENTION

Semiconductor device fabrication is a commonly used process for creating integrated circuits on a semiconductor wafer by using multiple-step sequence of photolithographic and chemical processing steps. As a part of the process, the integrated circuits created on the semiconductor wafer are typically tested for functional defects by applying special test patterns to them.

An exemplary device for testing integrated circuits on a semiconductor wafer comprises a chuck for holding the semiconductor wafer and a probe card for probing the integrated circuits. The probe card is electrically connected to an electronic testing unit that can electrically test the integrated circuits according to a test program. The test program defines the contents of test patterns and the sequence by which they are applied to the integrated circuits. For testing the integrated circuits, the probe card is held in place while the semiconductor wafer mounted on the chuck is moved with an actuator from one probing position to another. In each probing position, contact elements of the probe card are arranged in electrical contact with contact pads of a set of integrated circuits, which are then electrically tested with the electronic testing unit.

The testing device is vulnerable to vibrations induced by the operation of its electrical and mechanical instruments, and various external factors. The vibrations cause relative movement between the chuck and the probe card, which may lead to failed probing, especially in a case where the contact pads of the integrated circuits are very small. The vibrations can be reduced by placing the whole testing device or one or more of its electrical and mechanical instruments on passive or active vibration dampers. A passive vibration damper can be made of a viscoelastic material, which dampens vibrations. An active vibration damper proactively generates and sends cancelling signals based on the expected vibrations. A problem associated with the vibration dampers is that they are not effective enough in reducing the relative movement between the chuck and the probe card during the probing of the integrated circuits, especially in a case where the source of vibration is close to the chuck and the probe card.

### OBJECTIVES OF THE INVENTION

It is the main objective of the present invention to reduce or even eliminate the prior art problems presented above.

It is an objective of the present invention to provide a testing device for testing integrated circuits on a semiconductor wafer and a method for reducing vibration in a testing device. In more detail, it is an objective of the invention to provide a testing device and a method enabling to minimise the relative movement between a chuck and a probe card during the probing of integrated circuits. It is a further objective of the present invention to provide a testing device and a method enabling to accurately probe integrated circuits on a semiconductor wafer.

In order to realise the above-mentioned objectives, the testing device and the method according to the invention are characterised by what is presented in the characterising portions of the appended independent claims. Advantageous embodiments of the invention are described in the dependent claims.

### DESCRIPTION OF THE INVENTION

A testing device according to the invention comprises a movable support, a chuck attached to the movable support for holding a semiconductor wafer that comprises integrated circuits, a fixed support, a probe card attached to the fixed support for probing the integrated circuits on the semiconductor wafer, an actuator attached to the movable support for moving the chuck between probing positions so that the integrated circuits on the semiconductor wafer can be tested, and at least one pin attached to the movable support or the chuck in such a manner that when the chuck is at the probing position the at least one pin is pressed against the fixed support.

The testing device according to the invention is used to test integrated circuits on a semiconductor wafer. The semiconductor wafer is mounted on the chuck that can be moved between probing positions by using the actuator. In each probing position, one or more integrated circuits are probed by the probe card, which enables the testing of the integrated circuit(s).

The chuck is used to hold a semiconductor wafer during the testing of integrated circuits. The chuck can be, for example, a mechanical chuck that comprises a plurality of pins for holding the semiconductor wafer on a base plate of the chuck. Alternatively, the chuck can be, for example, an electrostatic chuck that comprises a metal base plate coated with a layer of dielectric material. By providing a voltage difference between the metal base plate and the semiconductor wafer, an electrostatic force holds the semiconductor wafer on the chuck. The chuck may also be a vacuum chuck having grooves on the surface of its base plate, wherein the grooves can be provided with vacuum to hold the semiconductor wafer in place on the base plate and make the semiconductor wafer flat in a case where it is warped.

The chuck is attached to the movable support. The movable support may comprise, for example, a column that is made of a metal, such as stainless steel, or other material having good mechanical properties. Preferably, in this case the chuck is attached to a first end of the column so that the base plate of the chuck is perpendicular to the longitudinal axis of the column, and the actuator is attached to a second end of the column.

The probe card is used to probe integrated circuits on a semiconductor wafer. The probe card comprises an electrical interface for electrical probing and/or an optical interface for optical probing of the integrated circuits. The probe card may comprise a printed circuit board (PCB) and one or more contact elements, which can be arranged in electrical contact with contact pads on the integrated circuits. The probe card can be, for example, a needle, vertical pin, or MEMS (Micro Electro-Mechanical System) type probe card depending on the shape and form of the contact elements. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver. Instead of or in addition to the contact element(s), the probe card may comprise one or more light sources for illuminating optical ports on the integrated circuits. The probe card may comprise a fibre arrangement for conducting the light to the optical port. The light source can be, for example, a light-emitting diode or a laser. Typically, the probe card is custom-built for each type of semiconductor wafer so that every integrated circuit on the semiconductor wafer can be tested.

The probe card is attached to the fixed support. The fixed support may comprise a plurality of structural elements, such as beams, plates and brackets, which are made of a metal, such as stainless steel, or other material having good mechanical properties.

The actuator is used to move the chuck between probing positions. By a probing position is meant a position of the chuck where one or more integrated circuits on a semiconductor wafer can be probed by the probe card. The probing can be electrical and/or optical depending on the type of the integrated circuits. The actuator is configured to move the chuck in a direction perpendicular to the base plate of the chuck, i.e. in a direction perpendicular to the semiconductor wafer that is mounted on the chuck. In many applications, this direction corresponds to the vertical direction. The actuator can also be configured to move the chuck in one or two directions parallel to the base plate of the chuck and/or to rotate the chuck around an axis perpendicular to the base plate of the chuck. The actuator can be configured to move the chuck both horizontally and vertically.

The testing device according to the invention is provided with at least one pin that is attached to the movable support or the chuck in such a manner that when the chuck is at the probing position the at least one pin is pressed against the fixed support. This means that, when the chuck is at the probing position, the at least one pin is arranged in contact with the fixed support. The friction between the pin and the fixed support prevents the relative movement between the chuck and the probe card in directions parallel to the base plate of the chuck. The frictional force is mainly affected by the surface texture of an end of the pin and a contact point on the fixed support as well as the pressing force impelling them together. The at least one pin is pressed against the fixed support by using the actuator. The arrangement can be rigid so that as long as the at least one pin remains in contact with the fixed support, the relative movement between the chuck and the probe card in a direction perpendicular to the base plate of the chuck is prevented. The arrangement can be suspended, which enables to compensate dimensional inaccuracies in the mechanical parts, such as the chuck, the probe card and the pin(s), and in their mounting in a direction perpendicular to the base plate of the chuck. In some applications, a slight movement between the chuck and the probe card in a direction perpendicular to the base plate of the chuck is allowable during the probing. In these cases, the arrangement is preferably suspended so that the at least one pin can be kept in contact with the fixed support despite of the slight relative movement in a direction perpendicular to the base plate of the chuck. The number of pins can be, for example, 1, 2-5, 6-10 or 11-20. Preferably, the testing device comprises a plurality of pins that are arranged on the periphery of the chuck. Preferably, the pins are arranged in such a manner that when the chuck is moved to the probing position, the pins come in contact with the fixed support simultaneously. The pin is preferably arranged in such a manner that its longitudinal axis is perpendicular to the base plate of the chuck.

The pin can be made of a metal, such as stainless steel, or other material having good mechanical properties.

An advantage of the testing device according to the invention is that it enables to reduce or even prevent the relative movement between the chuck and the probe card during the probing of integrated circuits on a semiconductor wafer. Another advantage of the testing device according to the invention is that it enables to accurately probe integrated circuits on a semiconductor wafer.

According to an embodiment of the invention the fixed support comprises a plate having a first side and a second side, wherein the at least one pin is pressed against the first side of the plate when the chuck is at the probing position. The probe card is arranged in connection with the plate and preferably attached to it. The plate is preferably arranged in such a manner that it is parallel to the base plate of the chuck. The plate can be made of a metal, such as stainless steel, or other material having good mechanical properties.

According to an embodiment of the invention the plate has an aperture, and the probe card is attached to the second side of the plate so that the integrated circuits can be probed through the aperture. The plate and its aperture can be, for example, circular. If the probe card has contact elements, the contact elements are arranged to extend through the aperture towards the chuck.

According to an embodiment of the invention the probe card is attached to the plate with a piezoelectric actuator. The piezoelectric actuator is an electrically controlled positioning element that functions based on the piezoelectric effect. The piezoelectric actuator enables to fine-tune the position of the probe card with respect to the chuck.

According to an embodiment of the invention each contact point on the plate for the pin comprises elastic material. The elastic material allows an end of the pin to press into the plate so that dimensional inaccuracies in the mechanical parts and in their mounting can be compensated in a direction perpendicular to the base plate of the chuck, and thus the semiconductor wafer can be arranged in a correct contact height. During the probing, the elastic material enables the pin to remain in contact with the plate despite of a slight relative movement between the chuck and the probe card in a direction perpendicular to the base plate of the chuck. The elastic material can be, for example, elastomer, rubber like urethane, nitril, or silicone.

According to an embodiment of the invention the plate is arranged to bend when the at least one pin is pressed against the plate. The bending of the plate enables to compensate dimensional inaccuracies in the mechanical parts and in their mounting in a direction perpendicular to the base plate of the chuck. The bending of the plate also enables to keep the pin in contact with the plate during the probing despite of a slight relative movement between the chuck and the probe card in a direction perpendicular to the base plate of the chuck.

According to an embodiment of the invention each of the at least one pin is provided with an elastic element. The elastic element enables to compensate dimensional inaccuracies in the mechanical parts and in their mounting in a direction perpendicular to the base plate of the chuck. The elastic element also enables to keep the pin in contact with the fixed support during the probing despite of a slight relative movement between the chuck and the probe card in a direction perpendicular to the base plate of the chuck. The elastic element can be, for example, a coil spring or an elastomer element.

According to an embodiment of the invention each of the at least one pin is provided with a linear actuator. The linear actuator is configured to move the pin in a direction perpendicular to the base plate of the chuck. The linear actuator enables to compensate dimensional inaccuracies in the mechanical parts and in their mounting in a direction perpendicular to the base plate of the chuck. The linear actuator also enables to keep the pin in contact with the fixed support during the probing despite of a slight relative movement between the chuck and the probe card in a direction perpendicular to the base plate of the chuck.

According to an embodiment of the invention the actuator is attached to the movable support with a spring assembly. The spring assembly enables to compensate dimensional inaccuracies in the mechanical parts and in their mounting in a direction perpendicular to the base plate of the chuck. The spring assembly also enables to keep the at least one pin in contact with the fixed support during the probing despite of a slight relative movement between the chuck and the probe card in a direction perpendicular to the base plate of the chuck. The spring assembly may comprise one or more coil springs.

According to an embodiment of the invention the at least one pin comprises a plurality of pins arranged on the periphery of the chuck. The pins are preferably arranged evenly on the periphery of the chuck to obtain an even load distribution. The number of pins can be, for example, 2-5, 6-10 or 11-20. Preferably, the number of pins is 3.

According to an embodiment of the invention the probe card comprises contact elements for electrical probing of contact pads on the integrated circuit. The contact elements are meant to be arranged in contact with the contact pads. The contact element can be, for example, a probe needle or a pin. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver.

According to an embodiment of the invention the probe card comprises a light source for optical probing of an optical port on the integrated circuit. The probe card may comprise a fibre arrangement for conducting the light to the optical port. The light source can be, for example, a light-emitting diode or a laser.

According to an embodiment of the invention the testing device comprises an electronic testing unit for testing the integrated circuits on the semiconductor wafer. The electronic testing unit is electrically connected to the probe card. The electronic testing unit tests the integrated circuits according to a test program, which defines the contents of test patterns and the sequence by which they are applied to the integrated circuits. The electronic testing unit may comprise a processor and a memory including computer program code, the memory and the computer program code being configured to, with the processor, cause the electronic testing unit to test the integrated circuits.

According to an embodiment of the invention the testing device comprises a chamber inside which the probe card and the chuck are arranged. The chamber allows the integrated circuits to be tested in a controlled environment. The conditions such as the pressure and temperature inside the chamber can be controlled using various devices. The testing device may comprise, for example, a pump connected to the chamber for controlling the pressure and a temperature control device connected to the chamber for controlling the temperature inside the chamber. The chamber can, for example, be made of stainless steel or aluminium.

The present invention also relates to a method for reducing vibration in a testing device that comprises a movable support, a chuck attached to the movable support for holding a semiconductor wafer that comprises integrated circuits, a fixed support, a probe card attached to the fixed support for probing the integrated circuits on the semiconductor wafer, and an actuator attached to the movable support for moving the chuck between probing positions so that the integrated circuits on the semiconductor wafer can be tested. The method according to the invention comprises providing the movable support or the chuck with at least one pin, and pressing, during the probing of the integrated circuit, the at least one pin against the fixed support to reduce the relative movement between the chuck and the probe card.

An advantage of the method according to the invention is that it enables to reduce or even prevent the relative movement between the chuck and the probe card during the probing of integrated circuits on a semiconductor wafer. Another advantage of the method according to the invention is that it enables to accurately probe integrated circuits on a semiconductor wafer.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

The exemplary embodiments presented in this text and their advantages relate by applicable parts to the testing device as well as the method according to the invention, even though this is not always separately mentioned.

### BRIEF DESCRIPTION OF THE DRAWINGS

- Fig. 1: illustrates a testing device according to a first embodiment of the invention,
- fig. 2: illustrates a testing device according to a second embodiment of the invention,
- fig. 3: illustrates a testing device according to a third embodiment of the invention,
- fig. 4: illustrates a testing device according to a fourth embodiment of the invention, and
- fig. 5: illustrates a testing device according to a fifth embodiment of the invention.

### DETAILED DESCRIPTION OF THE DRAWINGS

The same reference signs are used of the same or like components in different embodiments.

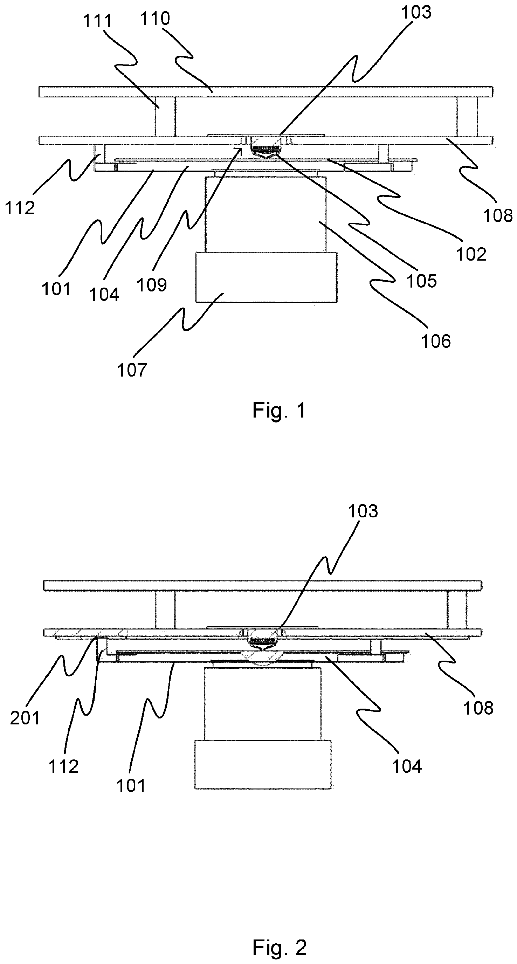

Fig. 1 illustrates a testing device according to a first embodiment of the invention. The testing device comprises a chuck 101 for holding a semiconductor wafer 102 that comprises integrated circuits (not shown in fig. 1), and a probe card 103 for probing the integrated circuits on the semiconductor wafer 102. The semiconductor wafer 102 is placed on a base plate 104 of the chuck 101 and restrained by a plurality of holding pins (not shown in fig. 1) during the testing of the integrated circuits. The probe card 103 comprises contact elements 105 for electrical probing of contact pads (not shown in fig. 1) on the integrated circuits.

The chuck 101 is attached to a movable support 106 that is attached to an actuator 107. The actuator 107 is used for moving the chuck 101 between probing positions so that the integrated circuits on the semiconductor wafer 102 can be tested. The actuator 107 can move the chuck 101 in a direction perpendicular to the base plate 104, and in two mutually perpendicular directions parallel to the base plate 104. Fig. 1 illustrates a situation where the chuck 101 is at one of the probing positions.

The probe card 103 is attached to an upper side of a plate 108 that comprises an aperture 109 through which the contact elements 105 are arranged to probe the contact pads of the integrated circuits. The plate 108 is arranged in such a manner that it is parallel to the base plate 104 of the chuck 101. The testing device comprises another plate 110 that is arranged parallel to the plate 108 and attached to it with rods 111. The plates 108 and 110 and the rods 108 form a fixed support for the probe card 103.

The testing device is provided with pins 112 that are attached to the periphery of the chuck 101 in such a manner that when the chuck 101 is arranged to the probing position the pins 112 are in contact with a lower side of the plate 108. The pins 112 are attached to the chuck 101 so that that their longitudinal axes are perpendicular to the base plate 104. The pins 112 are pressed against the plate with the actuator 107 to prevent the relative movement between the chuck 101 and the probe card 103 during the probing.

Fig. 2 illustrates a testing device according to a second embodiment of the invention. The testing device of fig. 2 differs from the testing device of fig. 1 in that contact points 201 on the plate 108 comprise elastic material. The elastic material allows an end of the pin 112 to press into the plate 108, whereby dimensional inaccuracies in the mechanical parts, such as the chuck 101, the probe card 103 and the pins 112 in a direction perpendicular to the base plate 104 can be compensated. During the probing, the elastic material enables the pin 112 to remain in contact with the plate 108 despite of a slight relative movement between the chuck 101 and the probe card 103 in a direction perpendicular to the base plate 104.

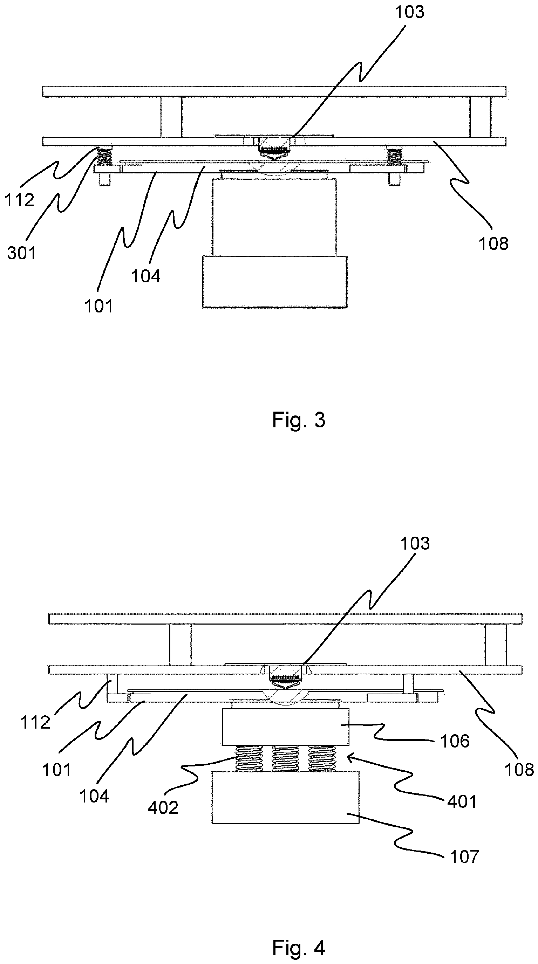

Fig. 3 illustrates a testing device according to a third embodiment of the invention. The testing device of fig. 3 differs from the testing device of fig. 1 in that the pins 112 are provided with coil springs 301. The coil spring 301 can compensate dimensional inaccuracies in the mechanical parts, such as the chuck 101 and the probe card 103 in a direction perpendicular to the base plate 104. The coil spring 301 enables to keep the pin 112 in contact with the plate 108 during the probing despite of a slight relative movement between the chuck 101 and the probe card 103 in a direction perpendicular to the base plate 104.

Fig. 4 illustrates a testing device according to a fourth embodiment of the invention. The testing device of fig. 4 differs from the testing device of fig. 1 in that the actuator 107 is attached to the movable support 106 with a spring assembly 401 that comprises coil springs 402. The spring assembly 401 can compensate dimensional inaccuracies in the mechanical parts, such as the chuck 101, the probe card 103 and the pins 112 in a direction perpendicular to the base plate 104. The spring assembly 401 enables to keep the pins 112 in contact with the plate 108 during the probing despite of a slight relative movement between the chuck 101 and the probe card 103 in a direction perpendicular to the base plate 104.

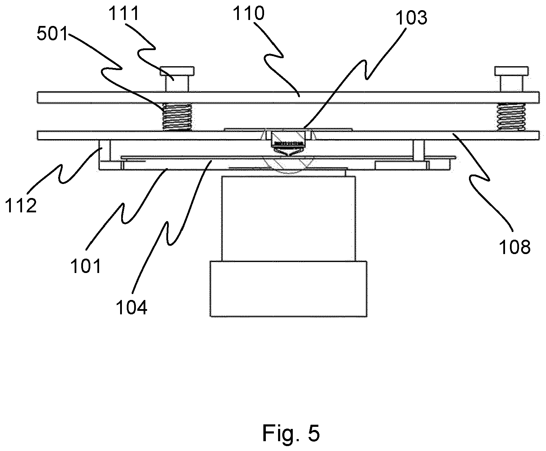

Fig. 5 illustrates a testing device according to a fifth embodiment of the invention. The testing device of fig. 5 differs from the testing device of fig. 1 in that the rods 111 attached between the plates 108 and 110 are provided with coil springs 501. The coil springs 501 can compensate dimensional inaccuracies in the mechanical parts, such as the chuck 101, the probe card 103 and the pins 112 in a direction perpendicular to the base plate 104. The coil springs 501 enable to keep the pins 112 in contact with the plate 108 during the probing despite of a slight relative movement between the chuck 101 and the probe card 103 in a direction perpendicular to the base plate 104.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A testing device, comprising:
- a movable support,
- a chuck attached to the movable support for holding a semiconductor wafer that comprises integrated circuits,
- a fixed support,
- a probe card attached to the fixed support for probing the integrated circuits on the semiconductor wafer, and
- an actuator attached to the movable support for moving the chuck between probing positions so that the integrated circuits on the semiconductor wafer can be tested,
**characterised in that** the testing device comprises:
- at least one pin attached to the movable support or the chuck in such a manner that when the chuck is at the probing position the at least one pin is pressed against the fixed support.

2. The testing device according to claim 1, **characterised in that** the fixed support comprises a plate having a first side and a second side, wherein the at least one pin is pressed against the first side of the plate when the chuck is at the probing position.

3. The testing device according to claim 2, **characterised in that** the plate has an aperture, and the probe card is attached to the second side of the plate so that the integrated circuits can be probed through the aperture.

4. The testing device according to claim 2 or 3, **characterised in that** the probe card is attached to the plate with a piezoelectric actuator.

5. The testing device according to any of claims 2 to 4, **characterised in that** each contact point on the plate for the pin comprises elastic material.

6. The testing device according to any of claims 2 to 5, **characterised in that** the plate is arranged to bend when the at least one pin is pressed against the plate.

7. The testing device according to any of the preceding claims, **characterised in that** each of the at least one pin is provided with an elastic element.

8. The testing device according to any of the preceding claims, **characterised in that** each of the at least one pin is provided with a linear actuator.

9. The testing device according to any of the preceding claims, **characterised in that** the actuator is attached to the movable support with a spring assembly.

10. The testing device according to any of the preceding claims, **characterised in that** the at least one pin comprises a plurality of pins arranged on the periphery of the chuck.

11. The testing device according to any of the preceding claims, **characterised in that** the probe card comprises contact elements for electrical probing of contact pads on the integrated circuit.

12. The testing device according to any of the preceding claims, **characterised in that** the probe card comprises a light source for optical probing of an optical port on the integrated circuit.

13. The testing device according to any of the preceding claims, **characterised in that** the testing device comprises an electronic testing unit for testing the integrated circuits on the semiconductor wafer.

14. The testing device according to any of the preceding claims, **characterised in that** the testing device comprises a chamber inside which the probe card and the chuck are arranged.

15. A method for reducing vibration in a testing device that comprises a movable support, a chuck attached to the movable support for holding a semiconductor wafer that comprises integrated circuits, a fixed support, a probe card attached to the fixed support for probing the integrated circuits on the semiconductor wafer, and an actuator attached to the movable support for moving the chuck between probing positions so that the integrated circuits on the semiconductor wafer can be tested, **characterised in that** the method comprises:
- providing the movable support or the chuck with at least one pin, and
- pressing, during the probing of the integrated circuit, the at least one pin against the fixed support to reduce the relative movement between the chuck and the probe card.
